# EUROPEAN PATENT APPLICATION

(11) **EP 0 982 809 A2**
(43) Date of publication of application: **01.03.2000**
(21) Application number: 99202389.5
(22) Date of filing: 20.07.1999
(51) Int. Cl.: H01R 12/38

(54) **Electric terminal for a flat electrical conductor and a method of connection**

(30) Priority: 27.08.1998 DE 19839114
(71) Applicant: Delphi Technologies, Inc., Troy, MI 48007 (US)
(72) Inventor: Gunay, Tarik, 41460 Neuss (DE); Schleife, Bernd, 42499 Huckeswagen (DE)
(74) Representative: Denton, Michael John

(57) **Abstract**

A method of electrically connecting an electric terminal (10) to a flat electrical conductor (26) comprising stamping in one-piece from sheet metal a terminal member (12), a first plate member (14) integrally connected with the terminal member, and a second plate member (18) integrally connected with the first plate member by at least one strap member (20); bending the strap member to be substantially U-shaped such that the first plate member overlies the second plate member; placing an end (24) of the flat conductor between the plate members before or after bending of the strap; and clinching the plate members and the end of the flat conductor to secure and electrically connect the plate members to the end of the flat conductor. Increased current handling capabilities.

## Description

### Technical Field

The present invention relates to a method of electrically connecting an electric terminal to a flat electrical conductor, and to an electric terminal for a flat electrical conductor.

### Background of the Invention

It is known to connect electric terminals to flat electrical conductors, such as flexible printed circuits (FPCs), by soldering, welding and crimping. These known arrangements have the disadvantage of a limited current handling capability, typically a maximum of 30 Amps. Soldering and welding can also induce temperature stresses in the flat conductor.

### Summary of the Invention

It is an object of the present invention to overcome the above mentioned disadvantages.

A method in accordance with the present invention of electrically connecting an electric terminal to a flat electrical conductor comprises stamping in one-piece from sheet metal a terminal member, a first plate member integrally connected with the terminal member, and a second plate member integrally connected with the first plate member by at least one strap member; bending the strap member to be substantially U-shaped such that the first plate member overlies the second plate member; placing an end of the flat conductor between the plate members; and clinching the plate members and the end of the flat conductor to secure and electrically connect the plate members to the end of the flat conductor.

The present invention also includes a method of electrically connecting an electric terminal to a flat electrical conductor comprising stamping in one-piece from sheet metal a terminal member, a first plate member integrally connected with the terminal member, and a second plate member integrally connected with the first plate member by at least one strap member; placing an end of the flat conductor on one of the plate members; bending the strap member to be substantially U-shaped such that the first plate member overlies the second plate member with the end of the flat conductor therebetween; and clinching the plate members and the end of the flat conductor to secure and electrically connect the plate members to the end of the flat conductor.

The present invention further comprises an electric terminal for a flat electrical conductor, which is stamped in one piece from sheet metal, comprising a terminal member; a first plate member integrally connected with the terminal member; and a second plate member integrally connected with the first plate member by at least one strap member; the strap member being substantially U-shaped such that the first plate member overlies the second plate member for positioning an end of the flat conductor between the plate members.

Provides an electrical connection between a terminal and a flat conductor which can handle larger currents than previously known arrangements, and does not subject the flat conductor to temperature stresses.

### Brief Description of the Drawings

The present invention will now be described, by way of example, with reference to the accompanying drawings, in which:
Figure 1 is a perspective view of an electric terminal in accordance with the present invention prior to folding;
Figure 2 is a perspective view of the terminal of Figure 1 after bending;
Figure 3 is a perspective view of the terminal of Figure 2 after insertion of an end of a flat electrical conductor;
Figure 4 is a perspective view of the terminal and conductor of Figure 3 after clinching; and
Figure 5 is a cross-sectional view through the clinch of Figure 4.

### Description of the Preferred Embodiment

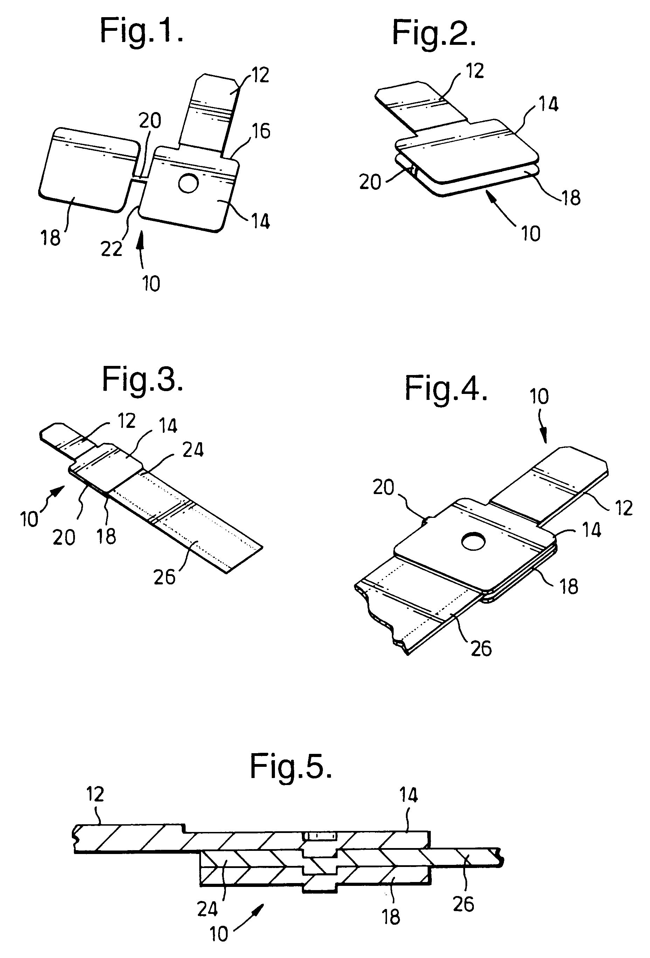

Referring to Figure 1, the electric terminal 10 is stamped in one-piece from sheet metal and comprises a terminal member 12, a first plate member 14 integrally connected with the terminal member on one side 16 of the first member, and a second plate member 18 integrally connected with the first plate member by a strap member 20 on an adjacent side 22 of the first plate member. The strap member 20 is bent into a substantially U-shape such that the first plate member 14 overlies the second plate member 18 as shown in Figure 2. The first and second plate members 14,18 lie in planes which are substantially parallel and spaced apart by a predetermined distance.

An end 24 of a flat electrical conductor 26, such as a flexible printed circuit (FPC) is then inserted in the space between the first and second plate members 14,18 as shown in Figure 3. The predetermined distance between the first and second plate members 14,18 is preferably the same as the thickness of the conductor 26. Finally the plate members 14,18 and the end 24 of the conductor 26 are clinched, as shown in Figures 4 and 5, to secure and electrically connect the terminal 10 to the conductor 26.

Such an arrangement allows larger current handling capabilities than prior known arrangements using soldering, welding, or crimping. Further, the flat conductor is not subjected to temperature stresses.

In an alternative method to that described above, the end 24 of the conductor 26 is placed on the first or second plate member 14,18 prior to bending of the strap member 20. The strap member 20 is then bent into a substantially U-shape with the end 24 of the conductor 26 positioned between the plate members 14,18. The clinching step is then performed.

Although the plate members 14,18 shown in the above embodiment are substantially square, it will be appreciated that other shapes for the plate members may be used, such as rectangular or circular.

The terminal member 12 in the above embodiment is shown as a male blade terminal. The terminal member may, however, be cut and bent to any suitable shape, such as a male contact pin.

Although the above embodiment describes an FPC 26, it will be appreciated that the present invention may be used with other types of flat electrical conductor.

## Claims

1. A method of electrically connecting an electric terminal (10) to a flat electrical conductor (26) comprising stamping in one-piece from sheet metal a terminal member (12), a first plate member (14) integrally connected with the terminal member, and a second plate member (18) integrally connected with the first plate member by at least one strap member (20); bending the strap member to be substantially U-shaped such that the first plate member overlies the second plate member; placing an end (24) of the flat conductor between the plate members; and clinching the plate members and the end of the flat conductor to secure and electrically connect the plate members to the end of the flat conductor.

2. A method of electrically connecting an electric terminal (10) to a flat electrical conductor (26) comprising stamping in one-piece from sheet metal a terminal member (12), a first plate member (14) integrally connected with the terminal member, and a second plate member (18) integrally connected with the first plate member by at least one strap member (20); placing an end (24) of the flat conductor on one of the plate members; bending the strap member to be substantially U-shaped such that the first plate member overlies the second plate member with the end of the flat conductor therebetween; and clinching the plate members and the end of the flat conductor to secure and electrically connect the plate members to the end of the flat conductor.

3. A method as claimed in Claim 1 or Claim 2, wherein the terminal member (12) is stamped as a male blade terminal.

4. A method as claimed in Claim 1 or Claim 2, wherein the terminal member is stamped and folded to form a male contact pin.

5. An electric terminal (10) for a flat electrical conductor (26), which is stamped in one piece from sheet metal, comprising a terminal member (12); a first plate member (14) integrally connected with the terminal member; and a second plate member (18) integrally connected with the first plate member by at least one strap member (20); the strap member being substantially U-shaped such that the first plate member overlies the second plate member for positioning an end of the flat conductor between the plate members.

6. An electric terminal as claimed in Claim 5, wherein the terminal member (12) is a male blade terminal.

7. An electric terminal as claimed in Claim 5, wherein the terminal member is a male contact pin.
